# EUROPÄISCHE PATENTSCHRIFT

(11) **EP 2 399 301 B1**
(45) Veröffentlichungstag und Bekanntmachung des Hinweises auf die Patenterteilung: **30.01.2013**
(21) Anmeldenummer: 10703632.9
(22) Anmeldetag: 11.02.2010
(51) Int. Cl.: H01L 31/18, H01L 31/048, B32B 37/14, B32B 37/22, C09D 175/16

(54) **SOLARZELLENMODUL UND VERFAHREN ZU SEINER HERSTELLUNG**
SOLAR CELL MODULE AND METHOD FOR THE PRODUCTION THEREOF
MODULE DE CELLULE SOLAIRE ET PROCÉDÉ DE FABRICATION CORRESPONDANT

(30) Priorität: 19.02.2009 DE 102009010990
(43) Veröffentlichungstag der Anmeldung: 28.12.2011
(73) Patentinhaber: KARL WÖRWAG LACK- UND FARBENFABRIK GMBH & CO. KG, 70435 Stuttgart (DE)
(72) Erfinder: DJUNAIDI, Terry, 71254 Ditzingen (DE); WARTA, Helge, 71254 Ditzingen (DE)
(74) Vertreter: Patentanwälte Ruff, Wilhelm, Beier, Dauster & Partner
(86) Internationale Anmeldenummer: PCT/EP2010/000860
(87) Internationale Veröffentlichungsnummer: WO 2010/094425

(56) Entgegenhaltungen:
- EP-A2- 0 361 351
- WO-A1-2007/009140
- DE-A1- 10 140 769
- DE-A1- 19 860 041
- DE-A1-102004 009 437
- DE-A1-102004 055 363
- JP-A- 2005 322 687
- US-A- 6 160 215
- US-A1- 2008 318 034
- US-B1- 6 258 441

## Beschreibung

Die vorliegende Erfindung betrifft ein Verfahren zur Herstellung eines Solarzellenmoduls, bei dem eine photovoltaische Schicht auf einen Träger aufgebracht und mit einer transparenten Schicht abgedeckt wird. Desweiteren betrifft die vorliegende Erfindung ein Solarzellenmodul, das durch ein solches Verfahren herstellbar ist, sowie die Verwendung eines Lackes bei der Herstellung eines solchen Moduls.

Ein Solarzellenmodul ist ein elektrisches Bauelement, mit dem in Licht enthaltene Strahlungsenergie direkt in elektrische Energie umgewandelt werden kann. Die physikalische Grundlage dafür ist der photovoltaische Effekt. Benötigt wird für den photovoltaischen Effekt ein p-n-Übergang, an dem bei Lichteinwirkung eine Ladungstrennung stattfindet. Das resultierende Spannungsgefälle kann zur Erzeugung nutzbarer elektrischer Energie dienen.

In klassischen Solarzellenmodulen findet man in der Regel eine photovoltaische Schicht aus kristallinem Silizium, die in einem aufwendigen Prozess aus einem Siliziumblock herausgeschnitten wurde. Da Licht nicht sehr tief in eine solche Schicht einzudringen vermag (nur ca. 10 µm), ist es sinnvoll, die photovoltaischen Schichten aus kristallinem Silizium in möglichst geringer Dicke herzustellen. Den beim Herausschneiden der Schicht aus dem Siliziumblock zur Anwendung kommenden Schneide- oder Sägeverfahren sind diesbezüglich allerdings Grenzen gesetzt.

Sehr viel dünnere photovoltaische Schichten finden sich bei den sogenannten Dünnschichtzellen. Solche dünne Schichten lassen sich beispielsweise durch Abscheidung aus der Gasphase direkt auf einem Träger aufbringen. Als Träger kommen z.B. Glas, Metallbleche oder auch flexible Materialien wie Kunststofffolien zum Einsatz. Bei einer Abscheidung auf flexible Träger weisen auch die resultierenden Solarzellenmodule eine gewisse Flexibilität auf, wodurch sich interessante Anwendungsbereiche erschließen.

Als Material für die photovoltaische Schicht einer Dünnschichtzelle kommt bevorzugt amorphes Silizium zum Einsatz. Daneben eignen sich weiterhin insbesondere auch mikrokristallines Silizium, Gallium-Arsenid, Cadmium-Tellurid oder Kupfer-Indium-(Gallium)-Schwefel-Selen-Verbindungen, insbesondere Kupfer-(Indium-Gallium)-Selen-Verbindungen (CIGS-Systeme).

Völlig unabhängig davon, welcher Typ Solarzellenmodul nun vorliegt, es ist stets erforderlich, die photovoltaische Schicht vor Beschädigungen zu schützen. Photovoltaische Schichten sind bereits aufgrund ihrer geringen Dicke äußerst empfindlich gegenüber mechanischen Einflüssen. Darüber hinaus müssen auch Oxidationseffekte jeglicher Art soweit wie möglich vermieden werden.

Klassisch werden photovoltaische Schichten daher unter einer Glasplatte angeordnet. Diese gewährt sowohl einen hervorragenden mechanischen Schutz als auch ausreichende Transparenz im Hinblick auf die energetisch zu verwertende Strahlung.

So ist es z.B. aus der US 6,160,215 bekannt, auf Dünnschichtzellen eine dünne Schicht aus Silikon zu übertragen, die von einer Schutzfolie bedeckt wird. Nach Abziehen der Schutzfolie lassen sich die Dünnschichtzellen auf eine Glasplatte aufkleben. Die Silikonschicht fungiert dabei als haftvermittelnde Schicht.

In jüngerer Zeit ist es insbesondere zum Schutz von Dünnschichtzellen üblich geworden, Kunststofffolien als flexible transparente Schutzsubstrate zu verwenden. Diese können über eine Zwischenschicht mit Hafteigenschaften (z.B. eine Zwischenschicht aus einem Ethylen-Vinylacetat-Copolymer) auf die photovoltaische Schicht aufgeklebt oder auflaminiert werden.

Bei den verwendeten Folien traten jedoch in der Vergangenheit diverse Probleme auf. So können bei starker Erwärmung durch Sonneneinstrahlung die Folien erweichen, was sie mechanisch weniger widerstandsfähig macht. Viele Folien verlieren außerdem mit der Zeit ihnen zugesetzte Weichmacher, was sie verspröden lässt und zu Beschädigungen führen kann. Ihre Witterungsbeständigkeit lässt so mit der Zeit nach. Solarzellenmodule mit Folien als transparenten Schutzsubstraten weisen eine entsprechend verringerte Lebenserwartung auf.

Es besteht deshalb nach wie vor ein Bedarf an effektiven Lösungen zum Schutz der photovoltaischen Schichten von Solarzellenmodulen. Der vorliegenden Erfindung lag die Aufgabe zugrunde, technische Lösungen aufzufinden, mit denen sich dieser Bedarf decken lässt. Es sollten so Solarzellenmodule mit hoher Lebenserwartung bereitgestellt werden, bei denen die aus dem Stand der Technik bekannten Probleme nicht oder nur in verringertem Maß auftreten.

Diese Aufgabe wird gelöst durch das Verfahren mit den Merkmalen des Anspruchs 1, das Solarzellenmodul mit den Merkmalen des Anspruchs 7 und die Verwendung mit den Merkmalen des Anspruchs 10. Bevorzugte Ausführungsformen des erfindungsgemäßen Verfahrens und des erfindungsgemäßen Solarzellenmoduls finden sich in den abhängigen Ansprüchen 2 bis 6 sowie 8 und 9. Bevorzugte Ausführungsformen der erfindungsgemäßen Verwendung finden sich in den abhängigen Ansprüchen 11 bis 20. Der Wortlaut sämtlicher Ansprüche wird hiermit durch Bezugnahme zum Inhalt dieser Beschreibung gemacht.

Gegenstand der vorliegenden Erfindung ist ein Verfahren zur Herstellung eines Solarzellenmoduls, bei dem eine photovoltaische Schicht auf einen Träger aufgebracht wird. Dies kann beispielsweise durch Abscheidung aus der Gasphase geschehen, entsprechende Vorgehensweisen (z.B. CVD- und PVD-Verfahren) sind dem Fachmann bekannt. In einem weiteren Schritt wird die photovoltaische Schicht auf dem Träger mit einer transparenten Schicht abgedeckt. Diese Schicht dient dem Schutz der photovoltaischen Schicht. Sie ist mindestens teilweise, vorzugsweise vollständig durchlässig für die durch die photovoltaische Schicht energetisch zu verwertende Strahlung.

Besonders zeichnet sich das erfindungsgemäße Verfahren dadurch aus, dass als transparente Schicht anstelle der eingangs erwähnten Schutzfolien ein härtbarer Lack aufgebracht wird. Diese Vorgehensweise vereint mehrere positive Effekte. Zum einen weist der härtbare Lack nämlich eine Flexibilität auf, die mindestens ebenso hoch ist wie die einer Folie. Zum anderen kann der Lack aber durch Aushärten in einen Zustand versetzt werden, indem er mechanisch sehr viel widerstandsfähiger ist als eine vergleichsweise weiche Kunststoffolie.

Besonders bevorzugt wird zur Aufbringung der transparenten Schicht der Lack in Form eines flexiblen Schichtverbundes bereitgestellt. Der Schichtverbund weist eine temporäre Trägerfolie auf, auf der eine Schicht aus dem härtbaren Lack angeordnet ist.

Zum Aufbringen des härtbaren Lackes wird der Schichtverbund mit der Seite, auf der die Lackschicht angeordnet ist, auf den Träger mit der photovoltaischen Schicht gepresst. In einem weiteren Schritt wird die temporäre Trägerfolie abgezogen, wobei die Lackschicht als transparente Schicht auf der photovoltaischen Schicht verbleibt.

Bei dieser bevorzugten Vorgehensweise wird die transparente Schicht also nicht erst auf der photovoltaischen Schicht gebildet, stattdessen wird sie mittels der temporären Trägerfolie auf die photovoltaische Schicht transferiert. Eine solche "Transferbeschichtung" hat den großen Vorteil, dass am Ort der Applikation selbst nur geringe Lösungsmittelbelastungen auftreten. Darüber kann eine einheitliche Schichtdicke gewährleistet werden. Die Applikation selbst ist sehr sehr einfach durchführbar.

Zur Herstellung der Lackschicht wird ein sogenannter Dual-Cure-Lack verwendet. Dual-Cure-Lacke härten in einem zweistufigen Prozess aus. Zum einen besitzen sie thermisch vernetzbare Bestandteile, zum anderen radikalisch vernetzbare. Es ist also erforderlich, die Lacke sowohl thermisch als auch photoinduziert auszuhärten.

Besonders bevorzugt wird im Rahmen des erfindungsgemäßen Verfahrens für die Lackschicht ein Lack verwendet, der eine doppelbindungshaltige, OH-funktionelle Komponente A, eine doppelbindungshaltige, NCO-funktionelle Komponente B sowie fakultativ eine doppelbindungshaltige Komponente C umfasst. Dieser bevorzugt einsetzbare Lack wird weiter unten noch ausführlicher beschrieben.

Besonders bevorzugt wird ein Schichtverbund verwendet, bei dem die Lackschicht auf der temporären Trägerfolie thermisch vorgehärtet ist.

Eine Endhärtung der Lackschicht erfolgt in bevorzugten Ausführungsformen, bevor die temporäre Trägerfolie abgezogen wird. Die Endhärtung erfolgt bevorzugt photoinduziert, insbesondere mit UV-Licht.

Der Einsatz von teilgehärteten Lackschichten kann insbesondere bei der Herstellung von flexiblen Solarzellenmodulen, die als Träger für die photovoltaische Schicht z.B. nur eine dünne, flexible Folie aufweisen, von Vorteil sein. So weist eine thermisch vorgehärtete Lackschicht in der Regel noch eine hohe Flexibilität auf. Ein Solarzellenmodul mit einer solchen Lackschicht kann gebogen und verformt werden, ohne dass es zu Beschädigungen der Lackschicht kommt. Durch Endhärtung kann die Lackschicht später in eine harte, widerstandsfähige Form überführt werden.

Bevorzugt wird die Lackschicht im übrigen nicht etwa unmittelbar auf die photovoltaische Schicht appliziert. Es ist stattdessen bevorzugt, auf die photovoltaische Schicht zuvor eine Zwischenschicht aufzubringen, insbesondere eine Zwischenschicht mit Hafteigenschaften. Derartige Zwischenschichten sind dem Fachmann grundsätzlich bekannt. Auch hierzu später noch mehr.

Auch die nach dem beschriebenen Verfahren hergestellten oder herstellbaren Solarzellenmodule sind Gegenstand der vorliegenden Erfindung.

Ein erfindungsgemäßes Solarzellenmodul umfasst einen Träger, eine darauf aufgebrachte photovoltaische Schicht und eine transparente Schicht, mit der die photovoltaische Schicht abgedeckt ist. Bei dem Träger kann es sich beispielsweise um eine Folie oder eine Platte aus Glas, aus einem Metall wie z.B. Aluminium oder aus einem Kunststoff (z.B. aus einem Fluorharz) handeln. Geeignete Träger sind dem Fachmann bekannt. Unter diesen werden besonders bevorzugt flexible Träger aus Folien, insbesondere aus Kunststofffolien, verwendet. Bei dem erfindungsgemäßen Solarzellenmodul handelt es sich entsprechend in bevorzugten Ausführungsformen um ein flexibles Solarzellenmodul.

Als photovoltaische Schicht kommen grundsätzlich alle Schichten in Betracht, die eingangs Erwähnung gefunden haben.

Bei der transparenten Schicht handelt es sich um eine Schicht aus einem gehärteten Lack, insbesondere aus einem gehärteten Dual-Cure-Lack (der unten noch näher beschrieben wird).

Wie bereits angedeutet wurde, kann zwischen der photovoltaischen Schicht und der transparenten Schicht in bevorzugten Ausführungsformen eine Zwischenschicht, insbesondere mit Hafteigenschaften, angeordnet werden. Entsprechend weist ein erfindungsgemäßes Solarzellenmodul zwischen der photovoltaischen Schicht und der transparenten Schicht bevorzugt eine solche Zwischenschicht auf. Gleiches gilt im übrigen auch im Hinblick auf die Schichtabfolge Träger / photovoltaische Schicht. Auch zwischen diesen beiden Schichten kann eine Zwischenschicht mit Hafteigenschaften angeordnet sein.

Als solche Zwischenschichten kommen grundsätzlich alle Haftvermittler in Frage, die ein Fachmann zum Aufkleben von Folien auf Substrate in Erwägung ziehen würde. Besonders hervorzuheben sind in diesem Zusammenhang Zwischenschichten aus Ethylen-Vinylacetat-Copolymerharzen.

Nun zur bereits angekündigten Beschreibung des Lackes, der im Rahmen des erfindungsgemäßen Verfahrens eingesetzt werden kann und der in ausgehärteter Form Bestandteil eines erfindungsgemäßen Solarzellenmoduls ist.

In Übereinstimmung mit den obigen Ausführungen ist die Verwendung eines Lackes, insbesondere eines Lackes wie er nachstehend beschrieben wird, bei der Herstellung eines Solarzellenmoduls von der vorliegenden Erfindung umfasst.

Besonders bevorzugt werden erfindungsgemäß Dual-Cure-Lacke verwendet. Besonders geeignet sind Dual-Cure-Lacke mit einer doppelbindungshaltigen, OH-funktionellen Komponente A, einer doppelbindungshaltigen, NCO-funktionellen Komponente B und gegebenenfalls einer doppelbindungshaltigen Komponente C.

Die einzelnen Komponenten A, B und C weisen dabei vorzugsweise die folgenden Eigenschaften auf:

### Komponente A:

- Festkörperanteil zwischen 30 Gew.-% und 100 Gew.-%,
- Doppelbindungsdichte zwischen 2 val/kg und 5 val/kg, insbesondere zwischen 3 val/kg und 4 val/kg (bei einem Festkörperanteil von 100 %) und
- OH-Gehalt zwischen 4 Gew.-% und 8 Gew.-%

### Komponente B

- Festkörperanteil zwischen 30 Gew.-% und 100 Gew.-%,
- Doppelbindungsdichte zwischen 1 val/kg und 4 val/kg, insbesondere zwischen 1 val/kg und 2 val/kg (bei einem Festkörperanteil von 100 %) und
- NCO-Gehalt zwischen 4 Gew.-% und 8 Gew.-%

### Komponente C

- Glasübergangstemperatur T_{g} zwischen -10 °C und 20 °C, insbesondere zwischen -5 °C und 5 °C,
- Festkörperanteil zwischen 30 Gew.-% und 100 Gew.-% und
- Doppelbindungsdichte zwischen 3 mol/kg und 6 mol/kg, insbesondere zwischen 4 mol/kg und 4,5 mol/kg (bei einem Festkörperanteil von 100 %)

Jede der Komponenten kann also einen Anteil Lösungsmittel aufweisen (bis zu 70 Gew.-%, siehe oben). Daneben können dem erfindungsgemäß einsetzbaren Lack noch ein oder mehrere zusätzliche Lösungsmittel zugesetzt sein.

Als fakultativen Bestandteil kann der Lack weiterhin ein oder mehrere Hilfsmittel enthalten, vorzugsweise eine Lack-Hilfsmittel-Kombination. In Frage kommen grundsätzlich alle handelsüblichen Hilfsmittel, die bei der Herstellung von Lacken (abgesehen von den Lackrohstoffen) üblicherweise benötigt werden, darunter insbesondere Hilfsmittel, die zur Einstellung und Stabilisierung der Eigenschaften von Lacken dienen. Beispiele hierfür sind Oberflächenadditive wie Verlaufsmittel und Entschäumer, Emulgatoren und Netz- und Dispergiermittel.

In Weiterbildung weist ein erfindungsgemäßer Lack bevorzugt die folgenden Zusammensetzung auf:
- zwischen 5 Gew.-% und 15 Gew.-% Komponente A,
- zwischen 10 Gew.-% und 45 Gew.-% Komponente B,
- zwischen 0 Gew.-% und 35 Gew.-% Komponente C,
- zwischen 0 Gew.-% und 8 Gew.-% des mindestens einen Lack-Hilfsmittels und
- zwischen 0 Gew.-% und 60 Gew.-% Lösungsmittel.

Es bleibt anzumerken, dass sich die Anteile vorzugsweise zu 100 Gew.-% ergänzen.

Bei dem mindestens einen zusätzlichen Lösungsmittel handelt es sich insbesondere um ein organisches Lösungsmittel. In bevorzugten Ausführungsformen umfasst es mindestens einen Ester und/oder mindestens ein Keton. Besonders geeignet sind beispielsweise Butylacetat oder Methylisobutylketon (MIBK).

Bei Komponente A handelt es sich insbesondere um ein Bindemittel auf Basis eines doppelbindungshaltigen Polyols, insbesondere auf Basis eines doppelbindungshaltigen, OH-funktionellen Polyestermethacrylats. Bevorzugt sind doppelbindungshaltige Polyole mit einem mittleren Molekulargewicht zwischen 100 Da und 5.000 Da. In g/mol ausgedrückt liegt ein besonders bevorzugter Wert für das mittlere Molekulargewicht zwischen 500 g/mol und 600 g/mol, insbesondere bei ca. 550 g/mol.

Komponente B basiert bevorzugt auf einem NCO-funktionellen Urethanacrylat, insbesondere auf einem aliphatischen Urethanacrylat. Urethanacrylate mit einem mittleren Molekulargewicht zwischen 800 Da und 5.000 Da sind besonders bevorzugt. In g/mol ausgedrückt liegt ein besonders bevorzugter Wert für das mittlere Molekulargewicht zwischen 1000 g/mol und 1400 g/mol, insbesondere bei ca. 1140 g/mol.

Als Komponente C wird besonders bevorzugt ein Bindemittel auf Basis eines Urethanacrylats eingesetzt, wobei das Urethanacrylat insbesondere ein mittleres Molekulargewicht Mm zwischen 1.000 Da und 3.000 Da, insbesondere zwischen 1.400 Da und 2.000 Da, aufweist.

Nach Härtung weist der Lack eine hohe Resistenz gegenüber Chemikalien wie z. B. Schwefelsäure oder Natronlauge auf. Auch Fermente wie Pankreatin führen in der Regel nicht zu einer Schädigung der Lackoberfläche. Der Lack ist außerordentlich bewitterungsstabil und gut geeignet für die vorgesehene Verwendung. Darüber hinaus verfügt er über hervorragende mechanische Eigenschaften, insbesondere über eine sehr hohe Kratzbeständigkeit.

Besonders bevorzugt wird der Lack im Rahmen der vorliegenden Erfindung in Form des bereits erwähnten flexiblen Schichtverbundes eingesetzt. In diesem Schichtverbund ist er auf einer temporären Trägerfolie angeordnet, die nach Applikation des Lackes abgezogen werden kann. Auch die Verwendung eines solchen Schichtverbundes bei der Herstellung eines Solarzellenmoduls ist damit Gegenstand der vorliegenden Erfindung.

Eine solche temporäre Trägerfolie kann grundsätzlich aus einer großen Anzahl verschiedener Kunststoffe bestehen. Besonders bevorzugt besteht sie aus einem Fluorpolymer wie Ethylen-Tetrafluorethylen (ETFE), aus einem Polyethylenterephthalat, aus einem Polyolefin, aus Polycarbonat, aus Acrylnitril-Butadien-Styrol (ABS), aus Acryl-Styrol-Acrylnitril (ASA), aus Acrylnitril-Butadien-Styrol/Polycarbonat (ABS/PC), aus Acryl-Styrol-Acrylnitril/Polycarbonat (ASA/PC), aus Polycarbonat/PolybutylenTerephthalat (PC/PBT), aus Polyacrylat, aus Polystyrol, aus Polymethylmetacrylat und/oder aus Polyvinylacetat.

Erfindungsgemäß verwendbare flexible Schichtverbünde sind ausführlich in der noch nicht veröffentlichten DE 10 2007 040 376.5 der Anmelderin beschrieben. Die entsprechenden Ausführungen zu den flexiblen Schichtverbünden und deren bevorzugten Merkmalen in diesem Dokument werden hiermit durch Bezugnahme zum Inhalt dieser Beschreibung gemacht.

Weitere Merkmale der Erfindung ergeben sich aus dem Beispiel in Verbindung mit den Unteransprüchen. Hierbei können einzelne Merkmale jeweils für sich oder zu mehreren in Kombination miteinander bei einer Ausführungsform der Erfindung verwirklicht sein. Die beschriebenen bevorzugten Ausführungsformen dienen lediglich zur Erläuterung und zum besseren Verständnis der Erfindung und sind in keiner Weise einschränkend zu verstehen.

### Beispiel

Eine erfindungsgemäß verwendbarer Lack setzt sich aus den folgenden Bestandteilen zusammen:

| | |
|---|---|
| Komponente C: | 30 Gew.-% |
| Urethanacrylat Bindemittel (fest) mit Glasübergangstemperatur von 2 °C und Doppelbindungsdichte von 4 mol/kg | |
| Komponente A: | 10 Gew.-% |
| Polyol, doppelbindungshaltig, Bindemittel fest, OH-Gehalt 5,7 %, Doppelbindungsdichte von 3,5 val/kg | |
| Irgacure 184 (Photoinitiator) | 1 Gew.-% |
| Irgacure 819 (Photoinitiator) | 0,40 Gew.-% |
| Tinuvin 400 (Lichtschutzmittel) | 0,70 Gew.-% |
| Tinuvin 292 (Lichtschutzmittel) | 0,70 Gew.-% |
| Tego Glide 435 (Oberflächenadditiv) | -0,5 Gew.-% |
| Tego Airex 931 (Entschäumer) | 1 Gew.-% |
| Lösemittel | 25,7 Gew.-% |
| Komponente B: | 30 Gew.-% |
| Urethanacrylat, NCO-haltig. Bindemittel fest, NCO-Gehalt 5,4 %, Doppelbindungsdichte von 1,5 val/kg | |

Ein solcher Lack wurde auf eine 50 µm dicke Folie aus Polyethylenterephthalat aufgerakelt. Nach Trocknung bei Raumtemperatur und anschließender thermischer Härtung im Ofen bei 100 °C wurde 1-5 min bei 23 °C abgekühlt. Die Dicke der entstehenden Lackschicht betrug ca. 25 µm.

Der entstandene Schichtverbund wurde anschließend unter Druck flächig auf eine sich auf einem Träger befindliche photovoltaische Schicht appliziert. Auf die photovoltaische Schicht war zuvor bereits eine dünne Klebefolie aus einem Ethylen-Vinylacetat-Copolymer aufgebracht worden. Es folgte eine UV-Härtung mit einem HG-Kaltlichtstrahler. Danach ließ sich die Folie aus Polyethylenterephthalat problemlos abziehen.

## Patentansprüche

1. Verfahren zur Herstellung eines Solarzellenmoduls, bei dem eine photovoltaische Schicht auf einen Träger aufgebracht und mit einer transparenten Schicht abgedeckt wird, wobei zur Aufbringung der Schicht
• ein flexibler Schichtverbund bereitgestellt wird, der eine temporäre Trägerfolie aufweist, auf der eine Lackschicht angeordnet ist,
• der Schichtverbund mit der Seite, auf der die Lackschicht angeordnet ist, auf die photovoltaische Schicht gepresst wird und
• die temporäre Trägerfolie abgezogen wird, wobei die Lackschicht als transparente Schicht auf der photovoltaischen Schicht verbleibt und
• wobei für die Lackschicht ein dual-cure Lack verwendet wird.

2. Verfahren nach Anspruch 1, **dadurch gekennzeichnet, dass** für die Lackschicht ein Lack umfassend eine doppelbindungshaltige, OH-funktionelle Komponente A, eine doppelbindungshaltige, NCO-funktionelle Komponente B und ggf. eine doppelbindungshaltige Komponente C verwendet wird.

3. Verfahren nach einem der vorhergehenden Ansprüche, **dadurch gekennzeichnet, dass** die Lackschicht auf der temporären Trägerfolie thermisch vorgehärtet ist.

4. Verfahren nach einem der vorhergehenden Ansprüche, **dadurch gekennzeichnet, dass** die Lackschicht endgehärtet wird, insbesondere mit UV-Licht, bevor die temporäre Trägerfolie abgezogen wird.

5. Verfahren nach einem der vorhergehenden Ansprüche, **dadurch gekennzeichnet, dass** auf die photovoltaische Schicht eine Zwischenschicht mit Hafteigenschaften aufgebracht wird, bevor die Lackschicht appliziert wird.

6. Solarzellenmodul, bevorzugt hergestellt oder herstellbar nach einem Verfahren nach einem der Ansprüche 1 bis 5, umfassend einen Träger, eine darauf aufgebrachte photovoltaische Schicht und eine transparente Schicht, mit der die photovoltaische Schicht abgedeckt ist, wobei es sich bei der transparenten Schicht um eine Schicht aus einem gehärteten dual-cure Lack handelt.

7. Solarzellenmodul nach Anspruch 6, **dadurch gekennzeichnet, dass** zwischen dem Träger und der photovoltaischen Schicht und/oder der photovoltaischen Schicht und der transparenten Schicht eine Zwischenschicht mit Hafteigenschaften angeordnet ist.

8. Verwendung eines dual-cure Lackes bei der Herstellung eines Solarzellenmoduls, insbesondere eines Solarzellenmoduls nach einem der vorhergehenden Ansprüche, wobei es bevorzugt ist, dass der dual-cure Lack eine doppelbindungshaltige, OH-funktionelle Komponente A, eine doppelbindungshaltige, NCO-funktionelle Komponente B und gegebenenfalls eine doppelbindungshaltige Komponente C umfasst. wobei die einzelnen Komponenten die folgenden Eigenschaften aufweisen:
Komponente A
Festkörperanteil zwischen 30 Gew.-% und 100 Gew.-%.
Doppelbindungsdichte zwischen 2 val/kg und 5 val/kg, insbesondere zwischen 3 val/kg und 4 val/kg (bei einem Festkörperanteil von 100 %) und
OH-Gehalt zwischen 4 Gew.-% und 8 Gew.-%
Komponente B
Festkörperanteil zwischen 30 Gew.-% und 100 Gew.-%.
Doppelbindungsdichte zwischen 1 val/kg und 4 val/kg insbesondere zwischen 1 val/kg und 2 vak/kg (bei einem Festkörperanteil von 100 %) und
NCO-Gehalt zwischen 4 Gew.-% und 8 Gew.-%
Komponente C
- Glasübergangstemperatur T_{g} zwischen -10 °C. und 20 °C, insbesondere zwischen -5 °C und 5 °C,
- Festkörperanteil zwischen 30 Gew.-% und 100 Gew.-% und
- Doppelbindungsdichte zwischen 3 mol/kg und 6 mol/kg, insbesondere zwischen 4 mol/kg und 4,5 mol/kg (bei einem Festkörperanteil von 100 %)

9. Verwendung nach Anspruch 8, **dadurch gekennzeichnet, dass** der Lack
- zwischen 5 Gew.-% und 15 Gew.-% Komponente A,
- zwischen 10 Gew.-% und 45 Gew.-% Komponente B,
- zwischen 0 Gew.-% und 35 Gew.-% Komponente C,
- zwischen 0 Gew.-% und 8 Gew.-% des mindestens einen Lack-Hilfsmittels und
- zwischen 0 Gew.-% und 60 Gew.-% Lösungsmittel
aufweist, wobei sich die Anteile vorzugsweise zu 100 Gew.-% ergänzten.

10. Verwendung nach einem der Ansprüche 8 oder 9, **dadurch gekennzeichnet, dass** es sich bei Komponente A um ein Bindemittel auf Basis eines doppelbindungshaltigen Polyols handelt, wobei es bevorzugt ist, dass das doppelbindungshaltige Polyol ein mittleres Molekulargewicht Mn zwischen 300 Da und 5000 Da aufweist.

11. Verwendung nach einem der Ansprüche 8 bis 10, **dadurch gekennzeichnet, dass** es sich bei Komponente B um ein Urethanacrylat, insbesondere um ein aliphatisches Urethanacrylat, handelt, insbesondere um ein Urethanacrylat mit einem mittleren Molekulargewicht Mn zwischen 800 Da und 5000 Da.

12. Verwendung nach einem der Ansprüche 8 bis 11, **dadurch gekennzeichnet, dass** es sich bei Komponente C um ein Bindemittel auf Basis eines Urethanacrylats handelt, insbesondere um ein Urethanacrylat mit einem mittleren Molekulargewicht Mn zwischen 1000 Da und 3000 Da, insbesondere zwischen 1400 Da und 2000 Da.

13. Verwendung nach einem der Ansprüche 8 bis 12, **dadurch gekennzeichnet, dass** der dual-cure Lack in Form eines flexiblen Schichtverbunds mit einer temporären Trägerfolie eingesetzt wird.

14. Verwendung nach Anspruch 13, **dadurch gekennzeichnet, dass** die temporäre Trägerfolie aus Kunststoff besteht, insbesondere aus einem Fluorpolymeren wie Ethylen-Tetrafluorethylen (ETFE), aus einem Polyethylenterephthalat, aus einem Polyolefin, aus Polycarbonat, aus Acrylnitril-Butadien-Styrol (ABS), aus Acryl-Styrol-Acrylnitril (ASA), aus Acrylnitril-Butadien-Styrol/Polycarbonat (ABS/PC), aus Acryl-Styröl-Acrylnitril/Polycarbonat (ASA/PC), aus Polycarbonat/Polybutylenterephthalat (PC/PBT), aus Polyacrylat, aus Polystyrol aus Polymethylmethacelat und/oder aus Polyvinylacetat.

## Claims

1. Method for the production manufacture of a solar cell module, wherein a photovoltaic layer is applied to a carrier and is covered by a transparent layer, wherein to apply the layer
• a flexible laminate is provided which has a temporary carrier film on which a coating layer is disposed,
• the laminate is pressed against the photovoltaic layer with the side on which the coating layer is disposed and
• the temporary carrier film is pulled off, wherein the coating layer remains on the photovoltaic layer as a transparent layer and
• wherein a dual-cure surface-coating material is used for the coating layer.

2. Method according to claim 1, **characterised in that** for the coating layer a surface-coating material comprising a double-bond-containing OH-functional component A, a double-bond-containing NCO-functional component B and, if desired, a double-bond-containing component C is used.

3. Method according to one of the above claims, **characterised in that** the coating layer is pre-cured thermally on the temporary carrier film.

4. Method according to one of the above claims, **characterised in that** the coating layer is end-cured, in particular with UV light, before the temporary carrier film is pulled off.

5. Method according to one of the above claims, **characterised in that** an intermediate layer with adhesive properties is applied to the photovoltaic layer before the coating layer is applied.

6. Solar cell module which is preferably produced or can be produced by a method according to one of claims 1 to 5, comprising a carrier, a photovoltaic layer applied thereto and a transparent layer that covers the photovoltaic layer, wherein the transparent layer is a layer of a cured dual-cure surface-coating material.

7. Solar module according to claim 6, **characterised in that** an intermediate layer with adhesive properties is disposed between the carrier and the photovoltaic layer and/or the photovoltaic layer and the transparent layer.

8. Use of a dual-cure surface-coating material for the production of a solar cell module, in particular a solar cell module according to one of the above claims, wherein it is preferred for the dual-cure surface-coating material to comprise a double-bond-containing OH-functional component A, a double-bond-containing NCO-functional component B and if desired a double-bond-containing component C, wherein the individual components have the following properties:
Component A
- A solids fraction between 30 and 100 per cent by weight
- A double-bond density between 2 val/kg and 5 val/kg, in particular between 3 val/kg and 4 val/kg (for a solids content of 100 per cent) and
- An OH content of between 4 and 8 per cent by weight
Component B
- A solids fraction between 30 and 100 per cent by weight
- A double-bond density between 1 val/kg and 4 val/kg, in particular between 1 val/kg and 2 val/kg (for a solids content of 100 per cent) and
- An OH content of between 4 and 8 per cent by weight
Component C
- A glass transition temperature T_{g} between -10 °C and 20 °C, in particular between -5 °C and 5 °C
- A solids fraction between 30 and 100 per cent by weight and
- A double-bond density between 3 mol/kg and 6 mol/kg, in particular between 4 mol/kg and 4.5 mol/kg (for a solids content of 100 per cent).

9. Use according to claim 8, **characterised in that** the surface-coating material contains
- between 5 and 15 per cent by weight of component A
- between 10 and 45 per cent by weight of component B
- between 0 and 35 per cent by weight of component C
- between 0 and 8 per cent by weight of at least one coating auxiliary agent
- between 0 and 60 per cent by weight solvent,
wherein the percentages preferably add up to 100 per cent by weight.

10. Use according to claim 8 or 9, **characterised in that** component A is a binder based on a double-bond-containing polyol, wherein it is preferred if the double-bond-containing polyol has a mean molecular weight Mn between 300 Da and 5000 Da.

11. Use according to one of claims 8 to 10, **characterised in that** component B is a urethane acrylate, in particular an aliphatic urethane acrylate, in particular a urethane acrylate with a mean molecular weight Mn between 800 Da and 5000 Da.

12. Use according to one of claims 8 to 11, **characterised in that** component C is a binder based on a urethane acrylate, in particular a urethane acrylate with a mean molecular weight Mn between 1000 Da and 3000 Da, in particular between 1400 Da and 2000 Da.

13. Use according to one of claims 8 to 12, **characterised in that** the dual-cure surface-coating material is used in the form of a flexible laminate with a temporary carrier film.

14. Use according to claim 13, **characterised in that** the temporary carrier film is of plastic, in particular a fluorinated polymer such as ethylene tetrafluoroethylene (ETFE), a polyethylene terephthalate, a polyolefin, polycarbonate, acrylonitrile butadiene styrene (ABS), acrylic styrene acrylonitrile (ASA), acrylonitrile-butadiene-styrene/polycarbonate (ABS/PC), acrylic styrene acrylonitrile/polycarbonate (ASA/PC), polycarbonate/polybutylene-terephthalate (PC/PBT), polyacrylate, polystyrene, polymethylmethacrylate and/or polyvinyl acetate.

## Revendications

1. Procédé de fabrication d'un module de cellule solaire, dans lequel une couche photovoltaïque est appliquée sur un support et recouverte d'une couche transparente, sachant que pour appliquer la couche
• est mise à disposition une couche composite souple qui présente un film porteur temporaire sur lequel est placée une couche de vernis,
• la couche composite est pressée sur la couche photovoltaïque avec la face sur laquelle est placée la couche de vernis, et
• le film porteur temporaire est retiré, la couche de vernis restant sur la couche photovoltaïque en tant que couche transparente, et
• un vernis « dual-cure » (à double durcissement) est utilisé pour la couche de vernis.

2. Procédé selon la revendication 1, **caractérisé en ce que** pour la couche de vernis est utilisé un vernis comprenant un composant A contenant des doubles liaisons, fonctionnel -OH, un composant B contenant des doubles liaisons, fonctionnel -NCO, et le cas échéant, un composant C contenant des doubles liaisons.

3. Procédé selon l'une des revendications précédentes, **caractérisé en ce que** la couche de vernis est prédurcie thermiquement sur le film porteur temporaire.

4. Procédé selon l'une des revendications précédentes, **caractérisé en ce que** la couche de vernis est durcie finalement, en particulier avec de la lumière UV, avant le retrait du film porteur temporaire.

5. Procédé selon l'une des revendications précédentes, **caractérisé en ce que** sur la couche photovoltaïque est placée une couche intermédiaire avec propriétés adhésives avant l'application de la couche de vernis.

6. Module de cellule solaire, de préférence fabriqué ou fabricable par un procédé selon l'une des revendications 1 à 5, comprenant un support, une couche photovoltaïque appliquée dessus et une couche transparente avec laquelle est recouverte la couche photovoltaïque, la couche transparente étant une couche d'un vernis « dual-cure » durci.

7. Module de cellule solaire selon la revendication 6, **caractérisé en ce qu'**une couche intermédiaire avec propriétés adhésives est placée entre le support et la couche photovoltaïque et/ou entre la couche photovoltaïque et la couche transparente.

8. Mise en oeuvre d'un vernis « dual-cure » dans la fabrication d'un module de cellule solaire, en particulier d'un module de cellule solaire selon l'une des revendications précédentes, sachant que de préférence le vernis « dual-cure » comprend un composant A contenant des doubles liaisons, fonctionnel -OH, un composant B contenant des doubles liaisons, fonctionnel -NCO, et le cas échéant un composant C contenant des doubles liaisons, les différents composants présentant les caractéristiques suivantes :
Composant A
- Part en solides comprise entre 30 % en poids et 100 % en poids,
- densité de doubles liaisons comprise entre 2 val/kg et 5 val/kg, en particulier entre 3 val/kg et 4 val/kg (pour une part en solides de 100 %) et
- teneur en OH comprise entre 4 % en poids et 8 % en poids
Composant B
- Part en solides comprise entre 30 % en poids et 100 % en poids,
- densité de doubles liaisons comprise entre 1 val/kg et 4 val/kg, en particulier entre 1 val/kg et 2 val/kg (pour une part en solides de 100 %) et
- teneur en NCO comprise entre 4 % en poids et 8 % en poids
Composant C
- Température de transition vitreuse T_{g} comprise entre -10 °C et 20 °C, en particulier entre -5 °C et 5 °C,
- part en solides comprise entre 30 % en poids et 100 % en poids et
- densité de doubles liaisons comprise entre 3 mol/kg et 6 mol/kg, en particulier entre 4 mol/kg et 4,5 mol/kg (pour une part en solides de 100 %).

9. Mise en oeuvre selon la revendication 8, **caractérisée en ce que** le vernis présente
- entre 5 % en poids et 15 % en poids du composant A,
- entre 10 % en poids et 45 % en poids du composant B,
- entre 0 % en poids et 35 % en poids du composant C,
- entre 0 % en poids et 8 % en poids de l'au moins un additif de vernis et
- entre 0 % en poids et 60 % en poids de solvant,
les parts se complétant de préférence à 100 % en poids.

10. Mise en oeuvre selon l'une des revendications 8 ou 9, **caractérisée en ce que** le composant A est un liant à base d'un polyol contenant des doubles liaisons, sachant que de préférence le polyol contenant des doubles liaisons présente un poids moléculaire moyen Mn compris entre 300 Da et 5000 Da.

11. Mise en oeuvre selon l'une des revendications 8 à 10, **caractérisée en ce que** le composant B est un acrylate d'uréthane, en particulier un acrylate d'uréthane aliphatique, en particulier un acrylate d'uréthane ayant un poids moléculaire moyen Mn compris entre 800 Da et 5000 Da.

12. Mise en oeuvre selon l'une des revendications 8 à 11, **caractérisée en ce que** le composant C est un liant à base d'un acrylate d'uréthane, en particulier un acrylate d'uréthane ayant un poids moléculaire moyen Mn compris entre 1000 Da et 3000 Da, en particulier entre 1400 Da et 2000 Da.

13. Mise en oeuvre selon l'une des revendications 8 à 12, **caractérisée en ce que** le vernis « dual-cure » est utilisé sous forme d'une couche composite souple avec un film porteur temporaire.

14. Mise en oeuvre selon la revendication 13, **caractérisé en ce que** le film porteur temporaire est constitué d'une matière synthétique, en particulier d'un polymère fluoré tel que l'éthylène-tétrafluoroéthylène (ETFE), d'un polyéthylène-téréphthalate, d'une polyoléfine, de polycarbonate, d'acrylonitrile-butadiène-styrène (ABS), d'acrylonitrile-styrène-acrylate (ASA), d'acrylonitrile-butadiène-styrène/polycarbonate (ABS/PC), d'acrylonitrile-styrène-acrylate/polycarbonate (ASA/PC), de polycarbonate/polybutylène-téréphthalate (PC/PBT), de polyacrylate, de polystyrène, de polyméthacrylate de méthyle et/ou d'acétate de polyvinyle.
